# FASCICULE DE BREVET EUROPEEN

(11) **EP 1 346 405 B1**
(45) Date de publication et mention de la délivrance du brevet: **11.11.2009**
(21) Numéro de dépôt: 01995728.1
(22) Date de dépôt: 17.12.2001
(51) Int. Cl.: H01L 21/335, H01L 29/76

(54) **PROCEDE DE FABRICATION D'UN ILOT DE MATIERE CONFINE ENTRE DES ELECTRODES, ET APPLICATIONS AUX TRANSISTORS**
VERFAHREN ZUR HERSTELLUNG EINER ZWISCHEN ELEKTRODEN EINGEFÜGTEN INSELSTRUKTUR UND DEREN ANWENDUNG AUF TRANSISTOREN
METHOD FOR MAKING AN ISLAND OF MATERIAL CONFINED BETWEEN ELECTRODES, AND APPLICATION TO TRANSISTORS

(30) Priorité: 18.12.2000 FR 0016488
(43) Date de publication de la demande: 24.09.2003
(73) Titulaire: COMMISSARIAT A L'ENERGIE ATOMIQUE, 75015 Paris (FR); STMicroelectronics S.A., 92120 Montrouge (FR)
(72) Inventeur: FRABOULET, David, F-38950 Quai en Chartreuse (FR); MARIOLLE, Denis, F-38100 Grenoble (FR); MORAND, Yves, F-38000 Grenoble (FR)
(74) Mandataire: Poulin, Gérard
(86) Numéro de dépôt international: PCT/FR2001/004018
(87) Numéro de publication internationale: WO 2002/050886

(56) Documents cités:
- EP-A- 0 844 671
- FR-A- 2 762 931
- US-A- 5 844 279
- US-A- 5 972 744
- US-A- 6 042 998
- GROSHEV A ET AL: "CHARGING EFFECTS OF A SINGLE QUANTUM LEVEL IN A BOX" PHYSICAL REVIEW LETTERS, AMERICAN PHYSICAL SOCIETY, NEW YORK, US, vol. 66, no. 8, 25 février 1991 (1991-02-25), pages 1082-1085, XP000207032 ISSN: 0031-9007
- FUJISHIMA M ET AL: "PROPOSAL OF A SCHOTTKY-BARRIER SET AIMING AT A FUTURE INTEGRATED DEVICE" IEICE TRANSACTIONS ON ELECTRONICS, INSTITUTE OF ELECTRONICS INFORMATION AND COMM. ENG. TOKYO, JP, vol. E 80-C, no. 7, 1 juillet 1997 (1997-07-01), pages 881-885, XP000740316 ISSN: 0916-8524

## Description

### Domaine technique

La présente invention concerne principalement un procédé de réalisation d'une microstructure comprenant un îlot de matière confiné entre deux électrodes formant des languettes. Elle concerne aussi la mise en oeuvre de ce procédé pour la réalisation de transistors fortement miniaturisés et en particulier pour la fabrication de transistors dits à "un" électron.

L'invention trouve des applications de façon générale dans les domaines de l'électronique et notamment pour la fabrication de circuits intégrés incluant des structures de transistor de commutation ou de mémoire.

### Etat de la technique antérieure

Les transistors CMOS (transistors métal-oxyde-semi-conducteur) complémentaires sont largement utilisés pour la réalisation de circuits de commutation ou pour des circuits de mémoires.

Une intégration toujours plus forte des circuits, accompagnée par une augmentation de la densité de composants, conduit à une diminution de la taille des composants et en particulier de la taille des transistors. La diminution de la taille des transistors introduit des contraintes toujours plus sévères pour les procédés de lithographie mis en oeuvre pour leur réalisation, et engendre des difficultés de fonctionnement croissantes.

Un type de transistor particulier s'avère bien adapté aux contraintes de la miniaturisation. Il s'agit des transistors dits à "un" électron ou transistors SET (Single Electron Transistor). Ces transistors s'avèrent également adaptés à un fonctionnement sous faible tension.

Dans ces transistors, une transition de l'état passant à l'état bloqué et inversement, est régie par un phénomène de blocage de Coulomb.

Les transistors à "un" électron comportent en général un îlot de matériau semi-conducteur de taille manométrique et connecté à deux électrodes par l'intermédiaire de jonctions tunnel. Une telle structure est décrite, par exemple, dans le document (1) dont les références complètes sont précisées à la fin de la présente description. Les transistors de ce type peuvent aussi être associés à une grille flottante pour en contrôler la charge et former ainsi une mémoire.

Une capacité électrique existant entre l'îlot et les électrodes doit être la plus faible possible pour ne pas limiter inutilement la fréquence de fonctionnement. En revanche, la capacité électrique entre l'îlot semi-conducteur et une grille du transistor doit être la plus importante possible.

Enfin, pour le fonctionnement des transistors à un électron à une température ambiante, la taille de leur îlot doit être minimisée. Or les tailles d'îlot que l'on voudrait atteindre pour un fonctionnement à 300 K, c'est-à-dire de l'ordre de 5 nm, sont en-deçà des limites ultimes des technologies de lithographie actuellement mises en oeuvre pour la fabrication de transistors.

L'état de la technique antérieure est encore illustré par les documents (2) à (14), brièvement commentés ci-après, et dont les références sont encore précisées à la fin de la description.

Les documents (2) et (3) montrent la fabrication de nano-points de stockage de charges et proposent l'utilisation de couches stochastiques de matériaux contenant des îlots de matériau semi-conducteur.

Les documents (4), (5), (6), et (7) montrent d'autres possibilités pour la fabrication d'îlots, soit par constrictions locales, par appauvrissement, grâce à une grille supplémentaire ou par ré-oxydation en utilisant des effets de coin.

D'autre documents se rapportent à des jonctions tunnel. Il s'agit par exemple des documents (8) et (9).

Indépendamment de la fabrication de transistors du type à "un" électron, un arrière-plan technologique concernant des procédés de lithographie ou de contrôle de la cote de petits objets par voie chimique, est donné par les documents (10), (11), et (12).

La réalisation d'éléments de transistor miniaturisés, et en particulier des électrodes de source et de drain miniaturisées, fait apparaître non seulement des difficultés liées aux techniques de photolithographie et de gravure, mais aussi des difficultés liées à l'interconnexion des éléments miniaturisés et à leur connexion à d'autres composants. Il faut en effet prévoir une liaison des éléments miniaturisés avec des contacts suffisamment larges pour assurer une compatibilité avec d'autres éléments relevant de la microélectronique traditionnelle.

### Exposé de l'invention

L'invention a pour but de proposer un procédé de fabrication d'une microstructure incluant un îlot de matière confiné entre deux électrodes, qui ne présente pas les limitations des procédés évoqués en relation avec l'analyse de l'état de la technique antérieure.

Un but de l'invention est en particulier de proposer un procédé permettant d'obtenir des électrodes les plus petites possibles, et séparées par un îlot de largeur la plus faible possible, aux limites des possibilités de résolution des équipements de photolithographie.

Un autre but est de proposer une possibilité d'augmenter l'épaisseur des électrodes tout en limitant la surface en regard entre l'îlot et les électrodes.

Un autre but encore est de proposer un procédé permettant un alignement parfait entre l'îlot et les électrodes, quelles que soient les dimensions de ces éléments, en autorisant notamment une réduction de la taille de l'îlot aux limites ultimes de la lithographie.

Toujours un autre but de l'invention est de proposer un procédé de fabrication d'une microstructure qui soit compatible, en termes de raccords électriques ou mécaniques, avec des éléments ou composantes fabriqués selon des techniques de la microélectronique traditionnelle, c'est-à-dire avec des composants dont les dimensions ne sont pas aux limites de la résolution des outils de lithographie.

L'invention a également pour but de proposer des procédés de fabrication de transistors qui mettent à profit le procédé de fabrication de l'îlot confiné. Ces transistors peuvent tout simplement être utilisés comme transistors de commutation ou peuvent être associés à une grille flottante pour constituer des mémoires.

Pour atteindre ces buts, l'invention a plus précisément pour objet un procédé de fabrication d'une microstructure comprenant un îlot de matière confiné entre deux électrodes formant des languettes, l'îlot de matière présentant des flancs latéraux parallèles et des flancs latéraux perpendiculaires aux languettes. Conformément à l'invention, les flancs latéraux de l'îlot sont définis par gravure d'au moins une couche, dite couche de gabarit, et les languettes sont formées par damasquinage.

On entend par damasquinage une technique de formation de motifs en un matériau, généralement conducteur, dans laquelle le matériau est déposé sur un substrat qui présente une empreinte négative, c'est-à-dire une empreinte en creux. Après le dépôt, le matériau conducteur peut être mis en forme, et en particulier peut subir un planage permettant de rendre sa surface affleurante au bord de l'empreinte, dans le plan de la surface du substrat. La technique de damasquinage est une technique connue en soi.

La combinaison des étapes de gravure, selon des techniques de lithographie, et de l'étape de damasquinage permet, grâce à l'invention, d'obtenir des microstructures aux dimensions particulièrement réduites.

L'étape de lithographie, qui permet de fixer la longueur de l'îlot parallèlement aux languettes que forment les électrodes, c'est-à-dire la distance qui sépare des extrémités des languettes en regard, est indépendante des étapes qui en fixent la largeur. Elle permet ainsi de réduire au minimum cette distance.

Selon l'invention le procédé comporte une première gravure de la couche de gabarit selon un premier masque de gravure présentant au moins une partie filiforme et une deuxième gravure de la couche de gabarit, postérieure à la première gravure, selon un deuxième masque de gravure présentant également au moins une partie filiforme, la partie filiforme du deuxième masque étant orientée selon une direction formant un angle non nul avec une direction d'orientation de la partie filiforme du premier masque, au voisinage d'un emplacement de formation de l'îlot.

Comme indiqué précédemment, un but de l'invention est de proposer un procédé permettant d'être mis en oeuvre aux limites de résolution des outils de lithographie, pour réduire la taille de l'îlot à des dimensions ultimes.

Les caractéristiques retenues ici, permettent d'utiliser les techniques de lithographie dans les conditions les plus favorables, c'est-à-dire la lithographie d'une ligne filiforme isolée.

L'emplacement de l'îlot est défini par l'intersection des directions des parties filiformes du premier et du deuxième masque. Il convient de noter ici que les premier et deuxième masques ne se croisent pas physiquement dans la mesure où le premier masque est préférentiellement retiré avant la deuxième étape de gravure.

Les dimensions les plus réduites de l'îlot sont avantageusement obtenues lorsque les directions d'orientation des masques sont sensiblement perpendiculaires.

La couche de gabarit qui peut être une couche unique ou un empilement de plusieurs sous-couches, sert, comme indiqué ci-dessus à former l'îlot de matière. Toutefois, cette couche de gabarit peut aussi être avantageusement mise à profit pour fixer simplement les dimensions des électrodes en dehors de l'emplacement de formation de l'îlot.

Au moins une partie des électrodes, et en particulier leur extrémité proximale, tournée vers l'îlot, se présente sous la forme d'une languette dont la section correspond à la largeur de l'îlot. Une extrémité distale des languettes peut en revanche être élargie pour faciliter le contact. électrique et/ou mécanique notamment avec d'autres composants dont la miniaturisation serait éventuellement moindre.

La première gravure de la couche de gabarit permet de former une empreinte, dite empreinte positive, dont la forme correspond à celle du premier masque. Il s'agit de la partie de la couche de gabarit protégée par le masque.

Après la première gravure et avant la deuxième gravure, on peut former autour de l'empreinte positive, une couche, dite de moule, épousant la forme de l'empreinte positive. On élimine alors une partie de l'empreinte positive non protégée par le deuxième masque, lors de la deuxième gravure, pour former avec la couche de moule, au moins une empreinte négative correspondant à un emplacement pour au moins une électrode. Ensuite, on effectue un dépôt conforme de matériau conducteur dans l'empreinte négative, pour former ladite électrode.

On entend par matériau conducteur, un matériau convenant à la formation d'électrodes. Il peut s'agir d'un matériau conducteur au sens usuel du terme, tel que, par exemple, un matériau métallique, ou un matériau semi-conducteur. Il s'agit, par exemple, de silicium polycristallin dopé.

Pour obtenir une structure avec une surface plane, propice à la formation d'autres éléments, le dépôt conforme de matériau conducteur peut être suivi d'une étape de planage.

Le procédé de l'invention peut être mis à profit pour la réalisation de transistors à effet de champ, de transistors à blocage de coulomb, de mémoires, et, de façon plus générale, pour tout type de composants dans lequel les électrodes, en forme languettes, peuvent constituer des électrodes de source et de drain.

L'invention concerne également un procédé de fabrication d'un transistor comprenant les étapes suivantes :
- le dépôt d'une couche de gabarit en un matériau isolant électrique sur une couche isolante d'un substrat,
- la formation d'un îlot de matière confiné entre une électrode de source et une électrode de drain, formant des languettes,
- la formation, au-dessus des languettes d'une couche de canal recouvrant l'îlot de matière, la couche de canal étant séparée des languettes par une couche d'isolant tunnel, et
- la formation d'une grille, isolée de la couche de canal, et disposée en regard de l'îlot de matière, dans lequel la formation de l'îlot de matière confiné entre les électrodes de source et de drain, est conforme aux procédés décrits ci-dessus, en utilisant la couche de gabarit.

Dans cette application particulière de l'invention, le canal du transistor est réalisé postérieurement à la formation des électrodes. Il peut être formé par exemple sur la surface plane obtenue après le planage du matériau conducteur des languettes.

Selon une variante, il est possible aussi de former le canal au sein même de l'îlot pour obtenir un transistor dit à un électron. Selon cette variante le procédé peut comporter les étapes suivantes :
- la formation d'un substrat avec une couche isolante enterrée supportant un empilement de couches avec, dans l'ordre à partir de la couche isolante enterrée, une couche de semi-conducteur, dite couche de canal, et une couche de recouvrement,
- la formation d'un îlot de matière confiné entre une électrode de source et une électrode de drain, formant des languettes, et,
- la formation d'une grille, isolée de la couche de canal, et disposée en regard de l'îlot de matière, dans lequel, la formation de l'îlot de matière confiné entre les électrodes de source et de drain, est conforme au procédé exposé précédemment, en utilisant l'empilement de couches comme couche de gabarit.

Selon cette variante, l'îlot n'est pas un îlot massif mais est composé de deux ou de davantage de sous-couches. L'une des sous-couches est formée par la couche de semi-conducteur. C'est cette sous-couche de l'îlot qui constitue le canal du transistor.

Lorsque des contraintes de contact risquent d'apparaître entre la couche de silicium et la couche de recouvrement, en raison du choix des matériaux pour ces couches, il est possible de prévoir une couche additionnelle intercalaire de relaxation de contraintes.

Pour achever la fabrication du composant, le procédé peut être complété par la réalisation d'une grille. La grille peut être une grille simple dans le cas d'un simple transistor, ou une grille double, incluant un élément flottant, dans le cas d'un transistor de mémoire.

L'étape de fabrication d'une grille peut être soit antérieure soit postérieure à la réalisation de la microstructure incluant le canal, la source et le drain. Dans le cas où la grille est une grille double, les deux parties de grille peuvent même être formées respectivement avant et après la microstructure incluant le canal.

Selon une première possibilité, la formation de la grille, postérieure à la formation de l'îlot, comprend l'élimination de la couche de recouvrement et de la couche de relaxation pour former un puits au-dessus de la couche de semi-conducteur de l'îlot, et la formation, dans l'ordre, d'une couche d'isolant de grille et d'une couche de grille s'étendant, dans cet ordre, dans le puits jusque sur la couche de semi-conducteur.

Selon une variante, le substrat peut être pourvu une couche de semi-conducteur sous la couche isolante enterrée, et la formation de la grille, antérieure à la formation de l'îlot peut comprendre le dopage local de ladite couche de semi-conducteur, le dopage s'étendant dans une région coïncidant avec un emplacement de l'îlot.

D'autres caractéristiques et avantages de l'invention ressortiront de la description qui va suivre, en référence aux figures des dessins annexés. Cette description est donnée à titre purement illustratif et non limitatif.

### Brève description des figures.

- La figure 1, est une coupe schématique d'un substrat utilisé pour la fabrication d'une microstructure selon un procédé conforme à l'invention.
- La figure 2 est une vue en coupe transversale du substrat de la figure 1 après une mise en forme d'une couche de gabarit.
- la figure 3 est une coupe selon un plan III-III du substrat de la figure 2.
- Les figures 4 et 5 sont des coupes schématiques transversales du substrat illustrant la formation d'une couche de moule entourant la couche de gabarit.
- La figure 6 est une vue en coupe selon un plan VI-VI du dispositif de la figure 5.
- Les figures 7, 8, et 9 sont respectivement une vue de dessus et des coupes transversales schématiques du substrat illustrant la formation d'une empreinte négative.
- La figure 10 est une coupe selon un plan X-X du dispositif de la figure 9.
- Les figures 11 et 12 sont des coupes schématiques du substrat de la figure 10 selon des plans de coupe XI-XI et XII-XII.
- Les figures 13 et 14 sont des coupes schématiques transversales du substrat illustrant la formation d'électrodes.
- La figure 15 est une coupe selon un plan XV-XV du dispositif de la figure 14.
- Les figures 16 et 17 sont des coupes schématiques selon des plans de coupe XVI-XVI et XVII-XVII indiqués sur la figure 15.
- Les figures 18 et 19 sont des coupes schématiques transversales du substrat illustrant des étapes complémentaires pour la fabrication d'un transistor.
- La figure 20 illustre une variante de l'étape correspondant à la figure 19.
- Les figures 21 et 22 sont des coupes schématiques d'un substrat, illustrant sa préparation pour la réalisation d'une microstructure selon une variante du procédé des figures 1 à 20.
- La figure 23 est une vue de dessus du dispositif de la figure 22.
- Les figures 24 et 25 sont des coupes schématiques du substrat illustrant l'enrobage d'un empilement de couches de gabarit.
- La figure 26 est une coupe selon un plan XXVI-XXVI du dispositif de la figure 25.
- La figure 27 est une coupe schématique transversale du substrat illustrant une étape de formation d'un îlot.
- La figure 28 est une coupe schématique transversale du substrat illustrant la formation d'une empreinte négative.
- La figure 29 est une coupe schématique transversale du substrat de la figure 28 illustrant la formation d'un isolant tunnel. Sur cette figure, les dimensions de l'îlot ont été augmentées pour des raisons de clarté.
- La figure 30 est une coupe schématique du substrat illustrant la formation d'électrodes.
- La figure 31 est une vue de dessus du dispositif de la figure 30 selon un plan de coupe XXXI-XXXI.
- Les figures 32, 33 et 34 sont des coupes schématiques du substrat, illustrant des étapes du procédé des figures 21 à 31, incluant la formation d'une grille enterrée.
- La figure 35 est une vue de dessus du dispositif de la figure 31, sur un champ agrandi, illustrant la formation d'une prise de contact sur la grille.
- La figure 36 est une coupe XXXVI-XXXVI du dispositif de la figure 35.
- Les figures 37, 38 et 39 sont des coupes d'un substrat pour la réalisation d'une microstructure selon un procédé conforme à l'invention, illustrant des étapes successives de sa préparation, pour y intégrer une grille enterrée.
- Les figures 40 et 41 sont des coupes schématiques du substrat de la figure 39 illustrant son utilisation dans un procédé de fabrication d'une microstructure, conformément à l'invention.
- Les figures 42 et 43 sont des coupes schématiques d'un dispositif conforme à la figure 30 et illustrent son utilisation pour la fabrication d'un transistor.
- La figure 44 est une coupe schématique d'un transistor réalisé selon un procédé conforme à l'invention et constitue une variante de celui illustré par la figure 43.

### Description détaillée de modes de mise en oeuvre de l'invention.

Dans la description qui suit, des parties identiques, similaires ou équivalentes des différentes figures sont repérées par les mêmes références numériques pour permettre un report plus aisé entre les figures. Par ailleurs, il convient de préciser que les différents éléments des figures ne sont pas représentés selon une échelle uniforme pour des raisons de clarté.

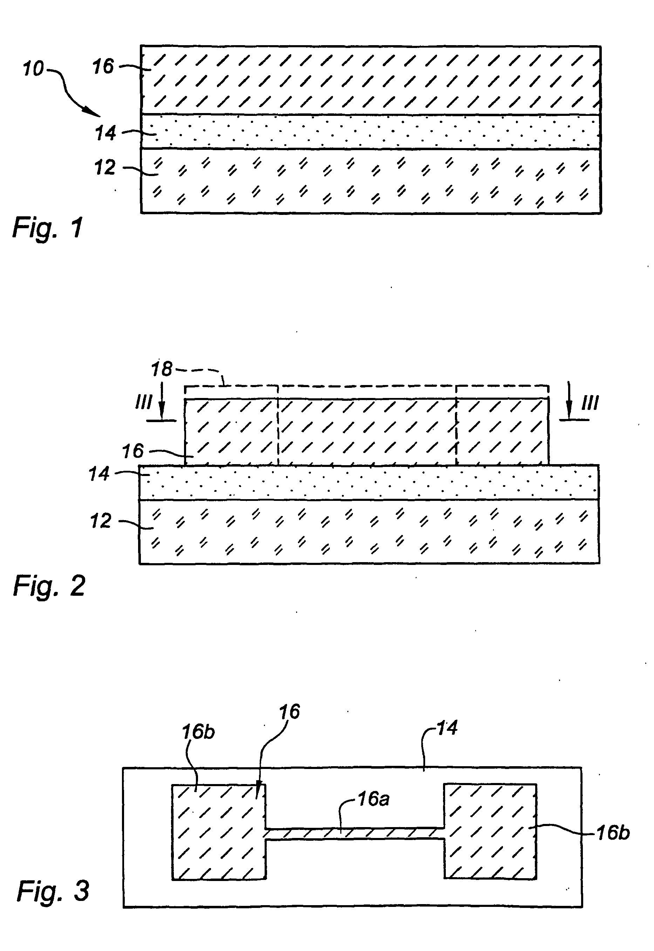

La figure 1 montre un substrat 10 utilisé pour la fabrication d'une microstructure selon un procédé conforme à l'invention. Le substrat 10 comporte une couche épaisse 12 constituant un support mécanique. Il s'agit par exemple d'une couche massive de semi-conducteur, tel que le silicium.

La couche épaisse 12 est recouverte d'une couche isolante électrique 14. Celle-ci est désignée par couche isolante "enterrée" dans la mesure où elle est recouverte par d'autres couches dans la suite du procédé. La couche isolante enterrée est, par exemple une couche d'oxyde de silicium déposée sur la couche épaisse ou obtenue par oxydation de la couche épaisse.

La couche isolante enterrée 14 est recouverte par une couche 16 dite couche de gabarit. Là encore, cette désignation choisie pour des raisons de commodité et se réfère à une utilisation ultérieure de cette couche. Les critères de choix des matériaux utilisés pour la couche de gabarit apparaîtront également dans la suite de la description. Dans l'exemple de la figure 1, il s'agit d'une simple couche de nitrure de silicium dont l'épaisseur est de 400 nm.

Un premier masque de gravure, réalisé selon des techniques usuelles de lithographie, est formé à la surface de la couche de gabarit et est indiqué sur la figure 2 avec la référence 18. Comme cela apparaîtra plus clairement dans la suite de la description, le masque 18 permet de fixer l'emplacement, la forme et la dimension d'électrodes qui seront réalisées dans des étapes ultérieures du procédé. Il permet également de fixer la largeur d'un îlot de matière qui sera formé dans la couche de gabarit.

Le masque 18 est utilisé pour préserver la partie de la couche de gabarit 16 qu'il recouvre, lors d'une première étape de gravure de cette couche. Comme le montre la figure 2, la gravure a lieu avec arrêt sur la couche isolante enterrée 14.

La figure 3, qui est une coupe de la figure 2 selon le plan III-III, permet de mieux voir la forme conférée à la couche de gabarit 16. Sur la figure 3, le masque de gravure 18 est éliminé.

Le masque présente une bande filiforme qui permet de préserver une partie également filiforme 16a de la couche de gabarit 16. La partie filiforme relie des pavés plus massifs 16b formés dans la couche de gabarit. Dans l'exemple illustré, la largeur de la partie filiforme 16a de la couche de gabarit 16 est de l'ordre de 50 nm.

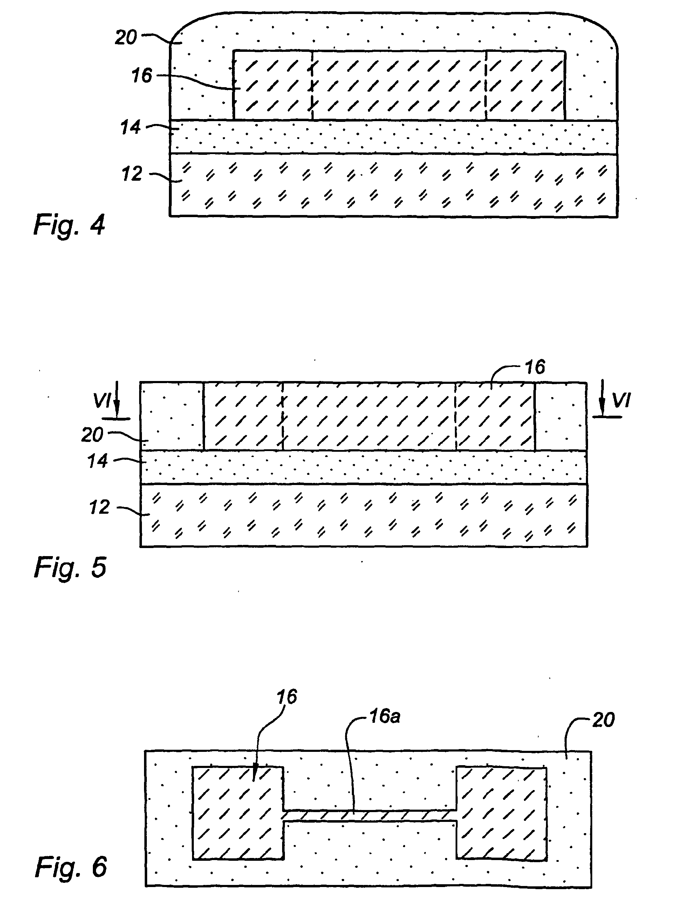

La figure 4, montre le dépôt conforme d'une couche 20, dite de moule, qui vient entourer et recouvrir la couche de gabarit 16 en en épousant ses formes. La couche de moule est par exemple une couche d'oxyde de silicium déposée.

La figure 5, montre une étape de planage lors de laquelle la partie de la couche de moule 20 qui recouvre la couche de gabarit 16 est éliminée. Le planage est effectué au moyen d'un polissage mécano-chimique avec arrêt sur la couche de gabarit 16, de sorte que la surface de cette couche et celle de la couche de moule soient coplanaires. Cette opération peut être optimisée par un choix approprié des matériaux de la couche de gabarit et de la couche de moule. Un résultat d'autant meilleur est obtenu lorsque la couche de gabarit présente une meilleure résistance à l'abrasion que la couche de moule de façon à remplir le rôle de couche d'arrêt de polissage.

La figure 6 est une vue en coupe selon le plan VI-VI et montre que la couche de moule 20 enveloppe désormais latéralement la couche de gabarit 16 en suivant ses contours.

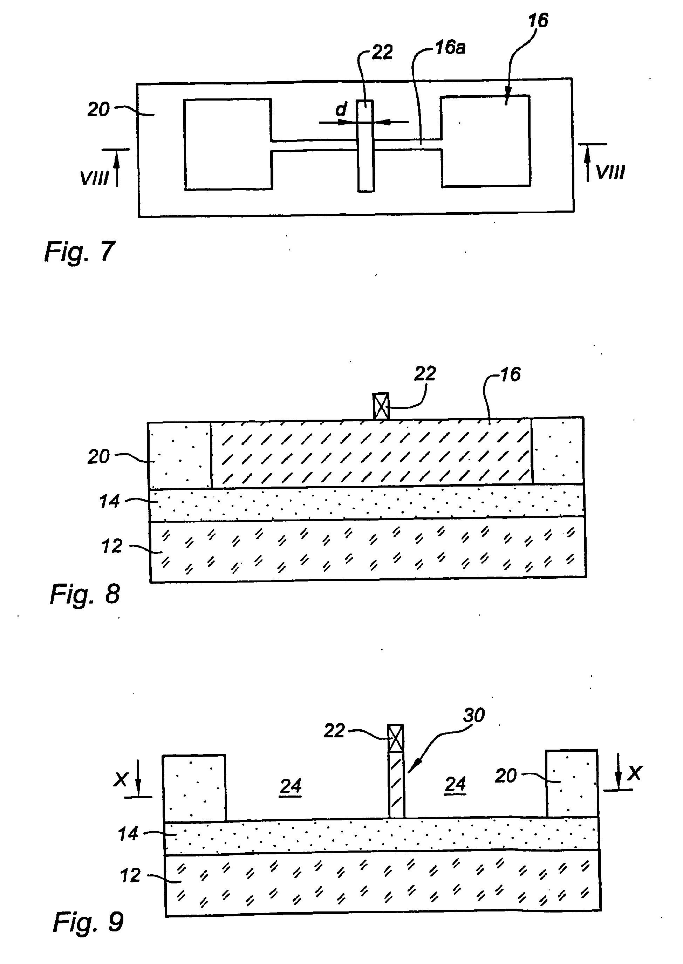

La figure 7 montre la formation d'un second masque de gravure 22 sur la surface libre plane de la couche de gabarit 16 et la couche de moule 20. Le masque 22 est également un masque filiforme et s'étend selon une direction sensiblement perpendiculaire à celle du premier masque de la figure 2 c'est-à-dire à celle de la partie filiforme 16a de la couche de gabarit. L'emplacement du second masque de gravure est choisi de façon a coïncider avec une section de la partie filiforme 16a de la couche de gabarit.

Dans l'exemple décrit, la largeur d du second masque 22 est également de 50 nm.

La figure 8 est une coupe du substrat et montre l'emplacement du second masque 22. Le substrat correspondant à la figure 8, est soumis à une gravure anisotrope sélective. Celle-ci permet d'éliminer sélectivement le matériau de la couche de gabarit 16, dans des régions où elle n'est pas protégée par le masque, en préservant la couche de moule.

Le caractère sélectif de cette gravure est un autre élément susceptible d'être pris en compte dans le choix des matériaux de la couche de gabarit et de la couche de moule. L'agent de gravure, et les matériaux sont choisis de telle façon que la gravure soit plus rapide sur le matériau de la couche de gabarit que sur celui de la couche de moule.

Comme le montre la figure 9 là gravure a lieu en utilisant la couche isolante enterrée 14 comme couche d' arrêt de gravure. Pour des raisons de simplification les figures ne tiennent pas compte d'éventuels effets de sur-gravure dus au caractère nécessairement limité de la sélectivité de gravure.

A l'exception de la partie de la couche de gabarit protégée par le second masque, la couche de gabarit est éliminée pour laisser place à une dépression 24 s'étendant de part et d'autre d'une partie 30 préservée. La dépression 24 est désignée par empreinte négative dans la suite du texte.

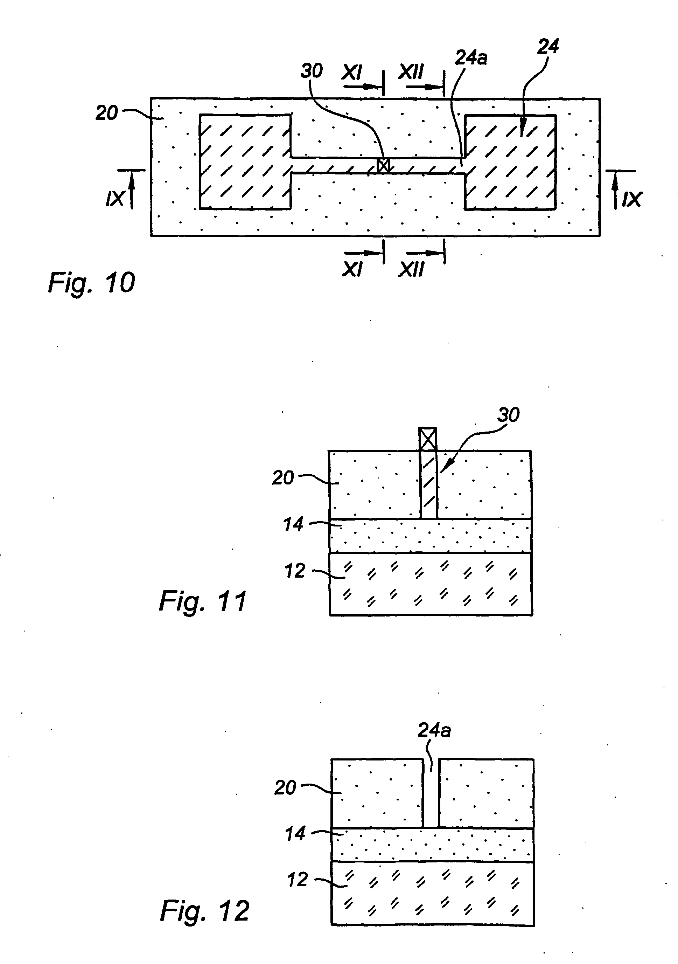

La figure 10, qui est une coupe selon le plan X-X indiqué sur la figure 9, permet de constater, en la comparant aux figures 3, 6 ou 7, que la forme de l'empreinte négative 24 correspond exactement à celle de la couche de gabarit. Elle montre également que la partie restante de la couche de gabarit forme désormais un îlot. Celui-ci est repéré avec la référence 30. Eventuellement, les dimensions de l'îlot pourraient, par exemple à ce stade du procédé, encore être réduites en soumettant le matériau de l'îlot à une gravure chimique, sélective et isotrope.

En comparant les figures 11 et 12 qui sont respectivement des coupes XI-XI et XII-XII indiquées sur la figure 10, on constate que la largeur de l'îlot 30 correspond exactement à celle d'une rainure 24a qui est l'empreinte négative correspondant à la partie filiforme de la couche de gabarit.

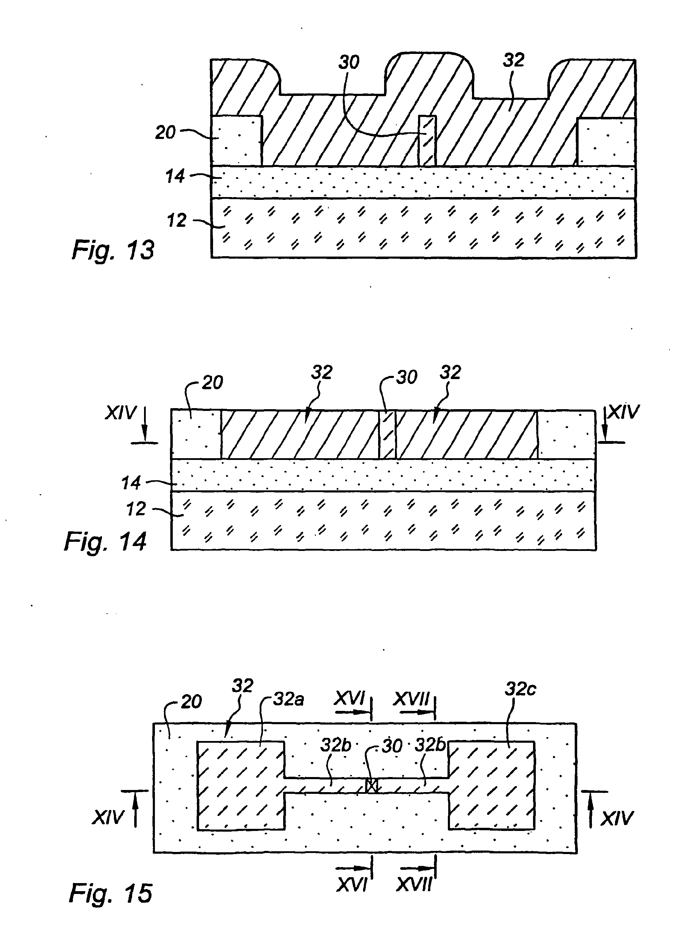

Après avoir éliminé le second masque de gravure une couche de matériau conducteur est déposée sur le substrat. La couche de matériau conducteur 32 est, par exemple, une couche de métal tel que de l'aluminium ou du nitrure de titane. La couche de matériau conducteur 32 présente, comme le montre la figure 13, une épaisseur suffisante pour venir combler entièrement l'empreinte négative, et pour venir déborder sur les bords de l'empreinte formés par la couche de moule 20. Le dépôt de la couche de matériau conducteur 32 est un dépôt conforme de sorte que ce matériau épouse la forme de l'empreinte négative et vienne en contact avec les flancs de l'îlot 30 qui font face à la rainure 24a de l'empreinte.

Le dépôt de matériau conducteur électrique 32 est poursuivi par une étape de planage lors de laquelle le matériau est soumis à une abrasion avec arrêt sur la couche de moule 20. Au terme de l'étape de planage, on obtient, comme le montre la figure 14, des électrodes 32 et 32 disposées respectivement de part et d'autre de l'îlot 30. Les électrodes, qui ne sont pas reliées entre elles, ne sont séparées que par le petit espace occupé par l'îlot 30.

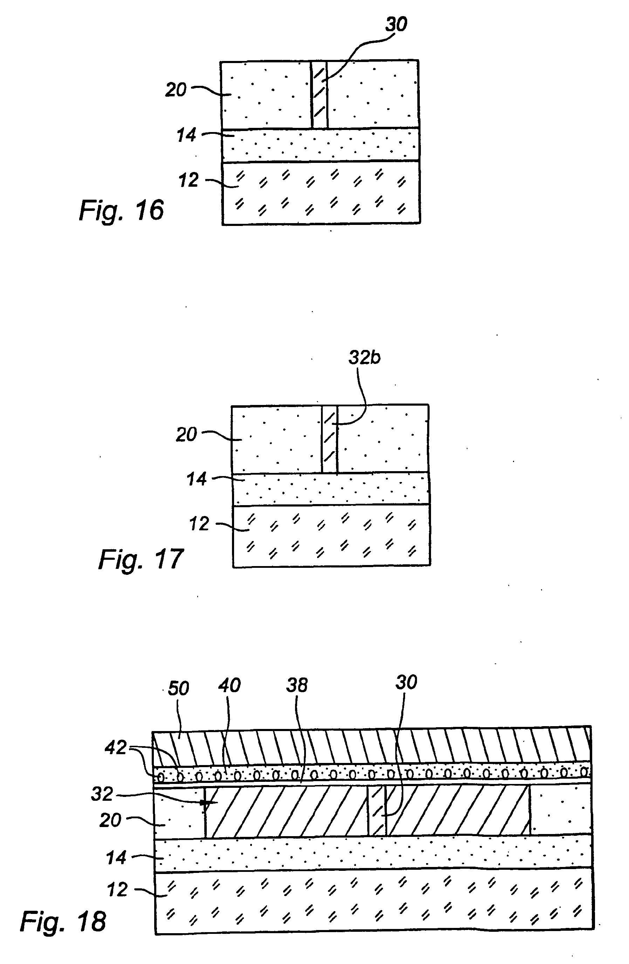

La figure 15, qui est une coupe du dispositif de la figure 14 selon le plan XIV-XIV, permet de mieux apprécier la forme des électrodes. On observe tout d'abord que la forme des électrodes correspond à celle de l'empreinte négative 24 de la figure 10, et donc à celle de la couche de gabarit des figures 3 ou 6. Chaque électrode présente une partie massive 34a et une languette fine 32b s'étendant de la partie massive vers l'îlot 30. La comparaison des figures 16 et 17, qui sont respectivement des coupes XVI-XVI et XVII-XVII à travers le dispositif de la figure 15, met en évidence que les languettes 32b présentent une largeur qui correspond à celle de l'îlot 30. Les languettes présentent, par ailleurs, des flancs alignés avec ceux de l'îlot. En l'occurrence, il s'agit des flancs parallèles à la direction reliant entre elles les parties massives des électrodes, c'est-à-dire parallèles au plan de coupe de la figure 14.

Les dispositifs des figures 14 et 15 peuvent être mis à profit pour la réalisation de composants à effet de champ tels que des transistors ou des mémoires.

Dans la description qui suit, on donne un exemple d'application qui est celui de la fabrication d'un transistor à nano-grains.

Un dispositif conforme à celui de la figure 14, est recouvert, comme le montre la figure 18, successivement d'une couche d'isolant tunnel 38, d'une couche 40 à nano-grains et une couche de métal de grille 50. Le métal de grille peut éventuellement être remplacé par un matériau conducteur non-métallique tel que le silicium polycristallin. La couche à nano-grains 40 comprend une pluralité de grains 42 sous forme cristalline ou colloïdale noyés dans un matériau isolant tel que SiO₂ ou SOG (Spin On Glass, verre). Les grains 42, dont la répartition est plus ou moins régulière sont des grains de matériau semi-conducteur ou métallique.

Le matériau isolant dans lequel les grains sont noyés peut servir d'isolant de grille. Toutefois, une couche supplémentaire de matériau diélectrique peut être prévue comme isolant de grille entre la couche à nano-grains et le métal de grille.

Par ailleurs, on entend par couche d'isolant tunnel, une couche en un matériau diélectrique, tel que de l'oxyde ou du nitrure de silicium dont l'épaisseur et/ou la constante diélectrique sont suffisamment faibles pour permettre la circulation d'un courant de canal par effet tunnel, lorsque le transistor est en régime conducteur. Pour des matériaux tels que SiO₂ ou Si₃N₄, l'épaisseur est par exemple de 1 nm.

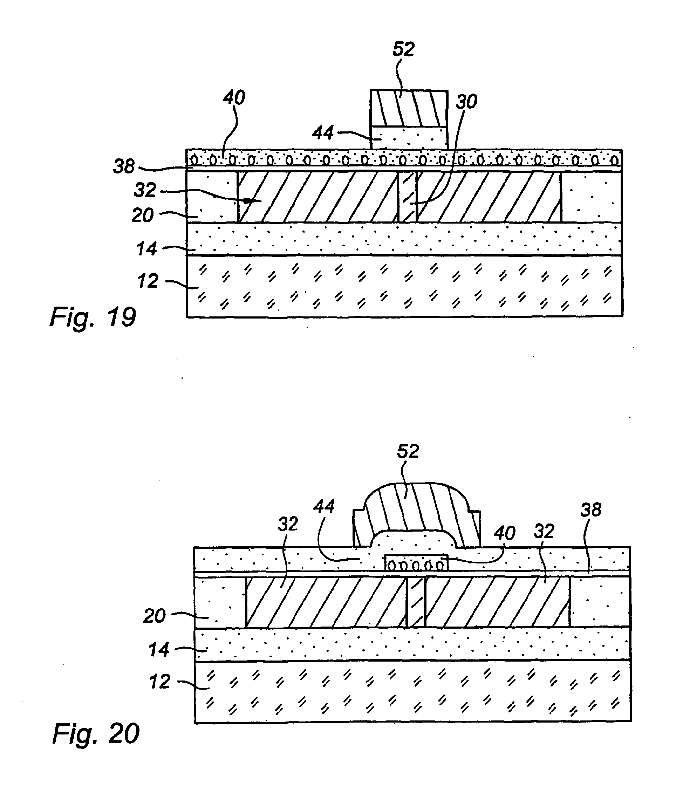

Une gravure de la couche de métal de grille 50, selon un masque non représenté, permet de mettre en forme une grille 52, qui comme le montre la figure 19, s'étend depuis une région située au-dessus de l'une des électrodes 32 jusqu'à une région située au-dessus de la deuxième électrode 32. La couche à nano-grains 40, ou tout au moins la partie de cette couche qui passe au-dessus de l'îlot constitue le canal du transistor.

Les électrodes 32 constituent les source et drain du transistor.

Une variante de réalisation du transistor de la figure 19 est illustrée par la figure 20. Selon cette variante, la couche à nano-grains 40 est mise en forme par gravure avant la dépôt de la couche de métal de grille. Lors de cette gravure, on ne laisse subsister qu'une portion de la couche à nano-grains 40 qui recouvre l'îlot 30 et qui s'étend jusqu'au-dessus des électrodes de source et de drain 32. Cette portion de couche, ou tout au moins la partie qui recouvre l'îlot, constitue le canal du transistor. Elle est désignée par couche de canal. Elle est séparée de la source et du drain par la couche d'isolant tunnel 38.

La couche de métal de grille est gravée en utilisant un masque de gravure (non représenté) un peu plus grand que celui utilisé pour la mise en forme de la couche à nano-grains, de sorte que la grille 52 coiffe la portion de couche de canal 40.

On peut également observer sur les figures 19 et 20 qu'une couche supplémentaire 44 d'isolant de grille sépare la grille 52 de la couche de canal 40. La couche d'isolant de grille est par exemple en oxyde de silicium.

Dans la suite de la description, un autre exemple d'application de l'invention est exposé : il s'agit de la fabrication d'un transistor du type à "un" électron. On ne rappelle pas ici le principe général du fonctionnement d'un tel transistor, qui est en soi connu, et qui est illustré par des documents évoqués dans la partie introductive du texte.

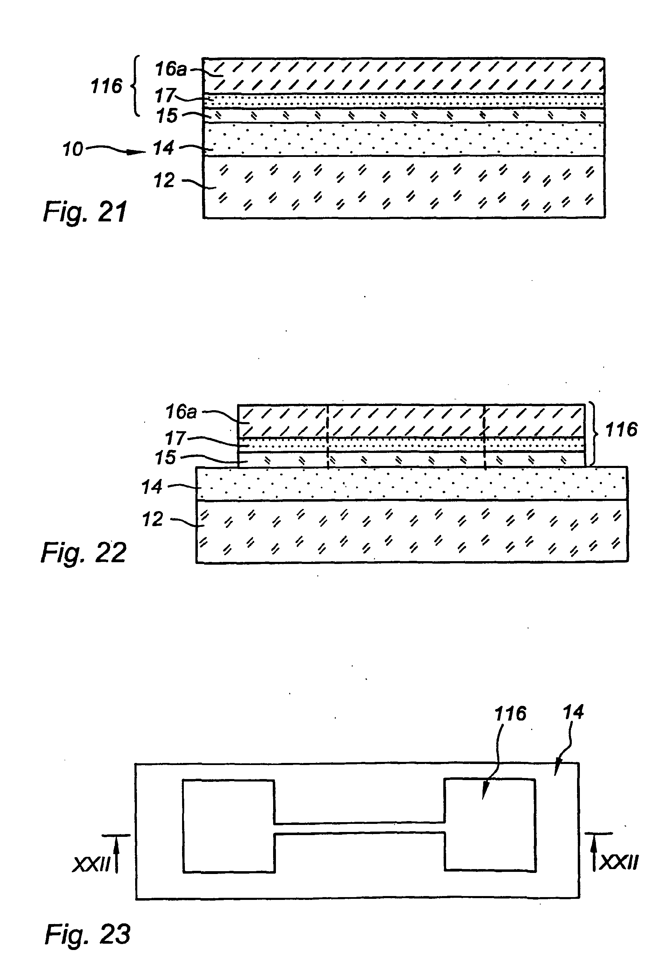

Une première étape du procédé, illustrée par la figure 21, est la préparation d'un substrat 10. Le substrat 10 de la figure 21 comprend une couche épaisse 12 de silicium, formant un support mécanique, une couche d'isolante électrique enterrée 14, et une couche mince superficielle 15 de semi-conducteur. Très avantageusement, on peut utiliser un substrat du type SOI, (silicium sur isolant, Silicon On Insulator), qui comprend justement une couche mince superficielle de silicium séparée d'un socle massif de silicium par une couche enterrée d'oxyde de silicium.

La préparation du substrat est poursuivie par la formation sur la couche de silicium 15, d'une couche de relaxation 17 puis d'une couche de recouvrement 16a.

La couche de recouvrement 16a présente des caractéristiques semblables à celles de la couche de gabarit 16 évoquée dans les exemples précédents. Elle n'est cependant pas directement assimilable à la couche de gabarit 16 de la figure 1. En effet, le rôle de la couche de gabarit sera dans la suite du procédé occupé par l'empilement de couches comprenant à la fois la couche mince de semi-conducteur 15, la couche de relaxation 17 et la couche de recouvrement 16a. Cet empilement de couches, ou plutôt de sous-couches constitue une nouvelle couche de gabarit repérée par la référence 116.

On peut préciser ici que la couche de relaxation 17, qui est une couche relativement fine, de l'ordre de 100 nm par exemple, a essentiellement pour rôle d'éviter des contraintes de contact entre la couche mince de semi-conducteur 15 et la couche de recouvrement 16a. Bien qu'elle ne soit pas indispensable, la couche de relaxation autorise un choix plus libre pour les matériaux de la couche de recouvrement. Les matériaux sélectionnés pour la couche de recouvrement sont en effet choisis principalement pour leurs propriétés comme matériau d'arrêt de polissage et comme matériau permettant une gravure sélective. Ces points apparaîtront encore dans la suite de la description. Enfin, il s'avère, dans une mise en oeuvre particulière de la formation d'une grille, évoquée également plus loin, que la couche de relaxation 17 peut aussi servir de couche d'arrêt de gravure.

Le substrat 10, préparé de cette façon, est soumis à une gravure selon un masque de gravure, non représenté, pour conférer à la couche de gabarit 116 une forme correspondant à celle du futur îlot et des futures électrodes. Cette forme est visible sur la figure 22 et sur la figure 23 qui est une vue de dessus du dispositif de la figure 22. La figure 22 montre que la gravure a lieu avec arrêt sur la couche isolante enterrée 14 et donc que l'ensemble des sous-couches de la couche de gabarit 116 sont gravées selon le même motif.

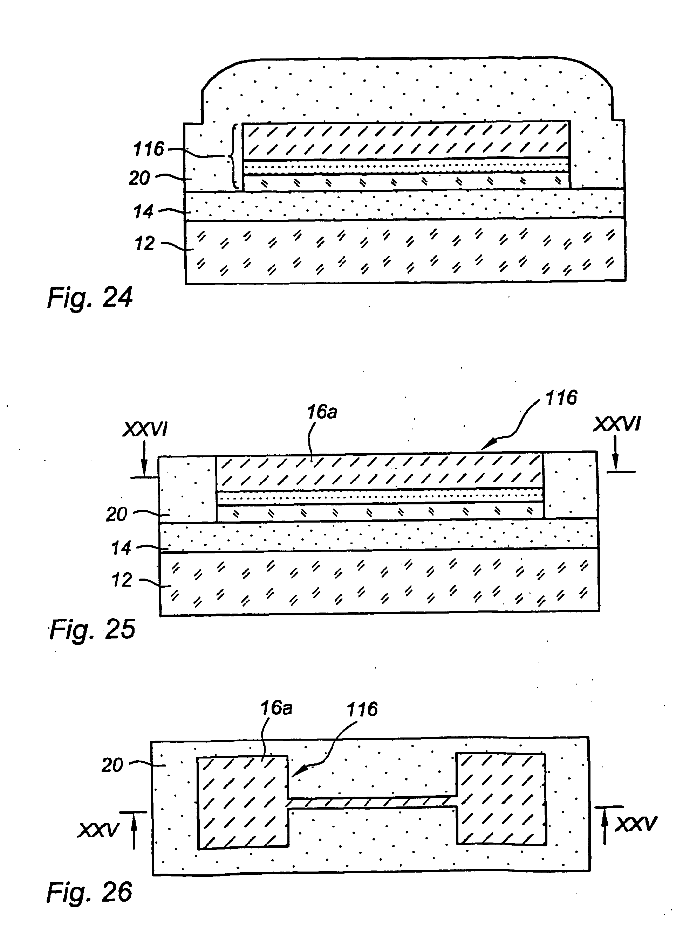

Les étapes ultérieures sont dans l'ordre, l'enrobage de la couche de gabarit 116 par une couche de moule 20, et le planage de la couche de moule avec arrêt sur la couche de recouvrement 16a, de façon à mettre cette dernière à nu. Ces étapes sont illustrées par les figures 24 à 26. Il n'est pas utile ici de procéder à une description plus détaillée de ces figures en raison de la forte analogie entre ces étapes de procédé et celles déjà décrites en référence aux figures 4 à 6.

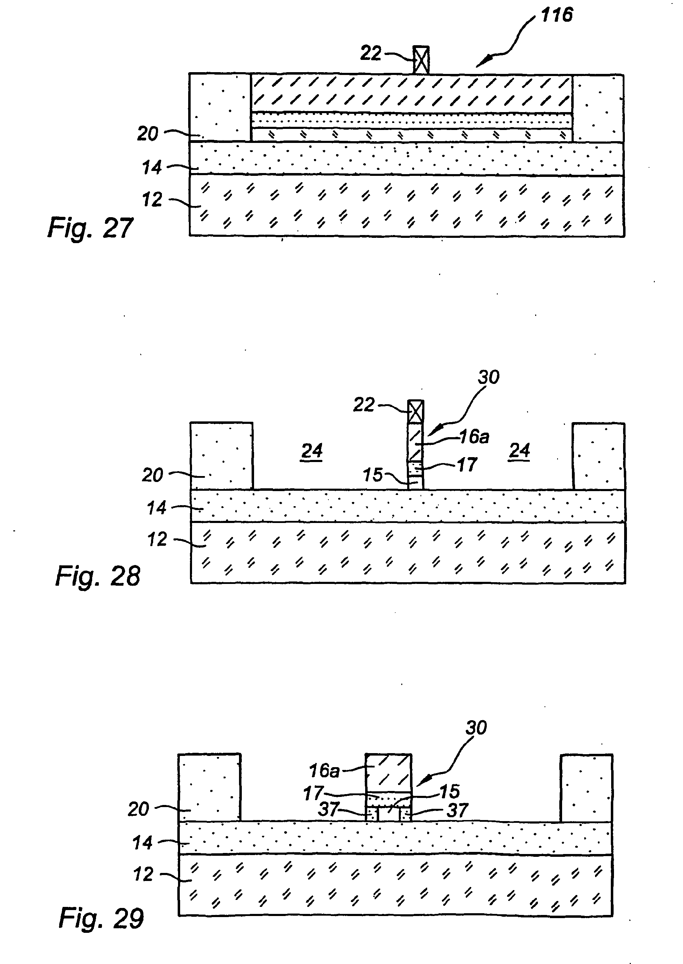

Les figures 27 et 28 montrent la deuxième gravure de la couche de gabarit destinée d'une part à fixer l'extension en longueur de l'îlot et d'autre part à fixer la forme de l'empreinte négative 24, de part et d'autre de l'îlot, destinée à recevoir les électrodes. La seconde gravure est réalisée en utilisant un masque de gravure filiforme 22 orienté perpendiculairement à la direction de la partie filiforme du masque utilisé pour la mise en forme de la couche de gabarit. Elle a lieu avec arrêt sur la couche isolante enterrée 14.

La figure 28 montre l'îlot 30 obtenu au terme de la gravure. L'îlot comprends toutes les couches de l'empilement formant la couche de gabarit, et en particulier la couche de semi-conducteur 15. En raison des dimensions particulièrement réduites que permet d'atteindre le procédé de l'invention, le volume de matière semi-conducteur de la couche 15 est très faible. Ce volume peut encore être diminué en réduisant la hauteur de la couche mince de semi-conducteur. L'amincissement peut avoir lieu, par exemple, par des cycles successifs d'oxydation et de désoxydation.

La fabrication du transistor peut être poursuivie, à ce stade du procédé, de la manière illustrée par les figures 13 et suivantes, précédemment décrites. On obtient alors un transistor dans lequel le canal est constitué par le petit volume du reliquat de la couche de semi-conducteur 15 de l'îlot 30. La fabrication de la grille est décrite ultérieurement.

Selon une autre possibilité, illustrée par la figure 29, on peut encore recouvrir les flancs de la couche de semi-conducteur 15 de l'îlot 30 d'un isolant tunnel 37. Il convient de noter que sur la figure, l'îlot 30 n'est pas représenté à la même échelle que sur la figure 29. Il est fortement dilaté pour mieux faire apparaître l'isolant tunnel 37. Lorsque le semi-conducteur de la couche 15 est du silicium, la formation de l'isolant tunnel 30 peut se résumer, par exemple, à une simple oxydation thermique des flancs. Il convient de remarquer à ce sujet que la figure 29 est une coupe à travers l'empreinte négative 24 et que seuls les flancs de la couche de semi-conducteur qui sont exposés dans l'évidement de cette empreinte sont garnis de la couche d'isolant tunnel 37.

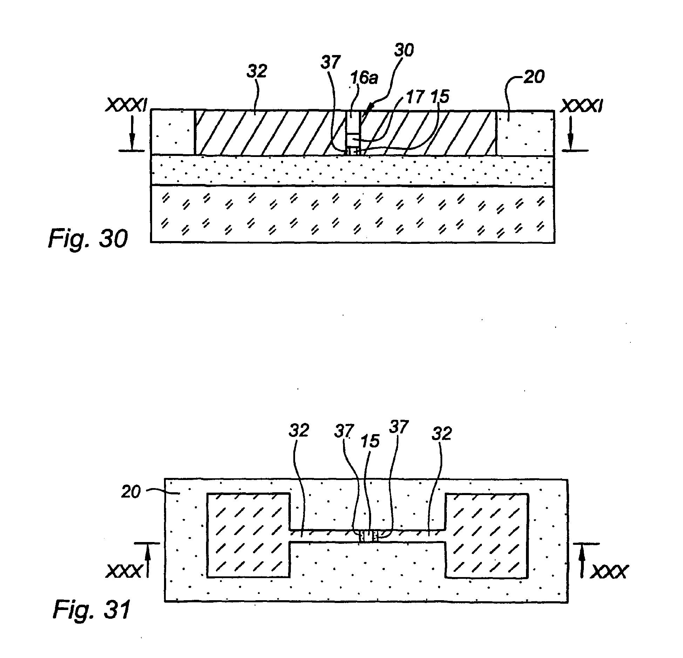

La fabrication du transistor se poursuit ensuite par la formation des électrodes de source et de drain 32 visibles sur la figure 30. La formation des électrodes de source et de drain peut avoir lieu comme indiqué précédemment par dépôt puis planage d'une couche de matériau conducteur. Sur la figure 30, l'îlot 30 est de nouveau représenté selon une échelle plus conforme aux figures précédentes.

La figure 31, est une vue en coupe selon le plan de coupe XXXI-XXXI indiqué sur la figure 30, et qui passe justement à travers le reliquat de la couche de semi-conducteur 15 de l'îlot 30. Elle montre que l'isolant tunnel 37, qui tapisse les flancs de la couche de semi-conducteur tournés vers les électrodes, sépare justement ces électrodes de la couche de semi-conducteur de l'îlot. L'isolant 37 a sensiblement la même fonction que la couche d'isolant tunnel 38 de la figure 19.

Un transistor avec un canal de très faible volume, isolé de la source et du drain par un isolant tunnel, permet un fonctionnement du type à un électron et permet d'exploiter le phénomène de blocage de Coulomb.

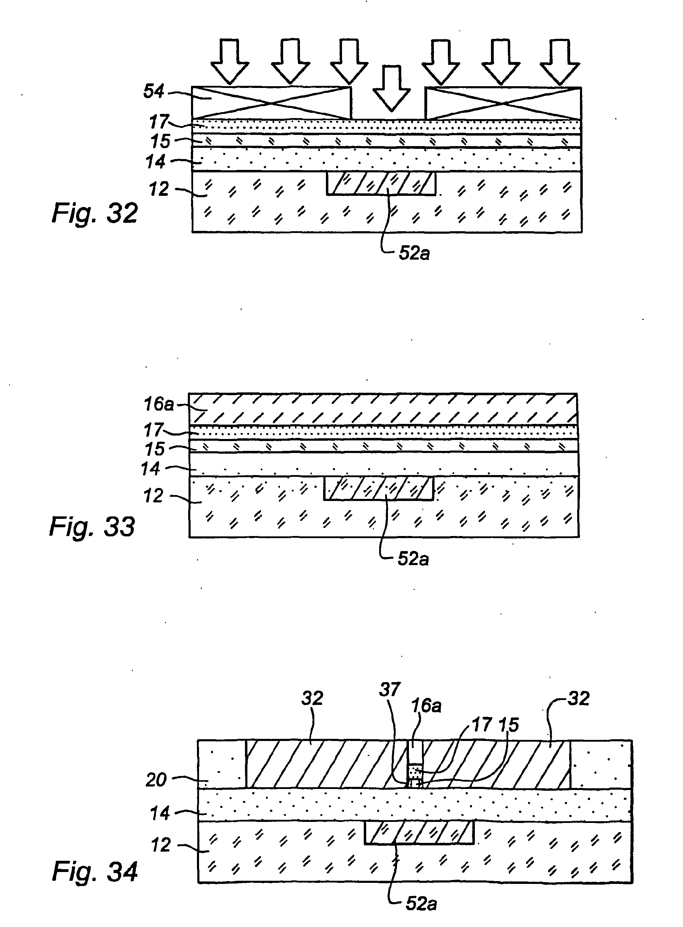

La formation de la grille du transistor peut avoir lieu de différentes manières. Une première possibilité est illustrée par les figures 32 à 34. Ces figures ne correspondent pas à des étapes subséquentes du procédé mais à des variantes des étapes précédemment décrites.

La figure 32 montre une étape qui prend place juste après la formation de la couche de relaxation 17 et avant la formation de la couche de recouvrement . Il s'agit d'une implantation d'impuretés dopantes destinées à modifier localement la conductivité de la couche de support 12.

Un masque d'implantation 54 présente à cet effet une ouverture coïncidant avec une zone dans laquelle l'îlot et donc le canal du transistor seront ultérieurement réalisés.

L'implantation des impuretés dopantes a lieu avec une énergie suffisante pour que celles-ci puissent traverser la couche de relaxation 17, la couche de semi-conducteur 15 et la couche isolante enterrée 14. Elle permet de former une grille enterrée 52a

Postérieurement à l'implantation, le masque d'implantation est retiré et la couche de recouvrement 16a est formée. Ces étapes correspondent à la figure 31. Le procédé de fabrication du transistor se poursuit alors de la façon décrite précédemment, en référence aux figures 22 à 30 pour obtenir le transistor de la figure 34. On observe sur la figure 34 que la couche enterrée 14 sert maintenant comme couche d'isolant de grille et sépare le grille 52a de la couche de semi-conducteur 15 de l'îlot 30 qui forme le canal. Il convient dans ce cas de conférer à cette couche une épaisseur compatible avec son utilisation comme isolant de grille, par exemple une épaisseur de l'ordre de 10 nm dans le cas d'une couche d'oxyde.

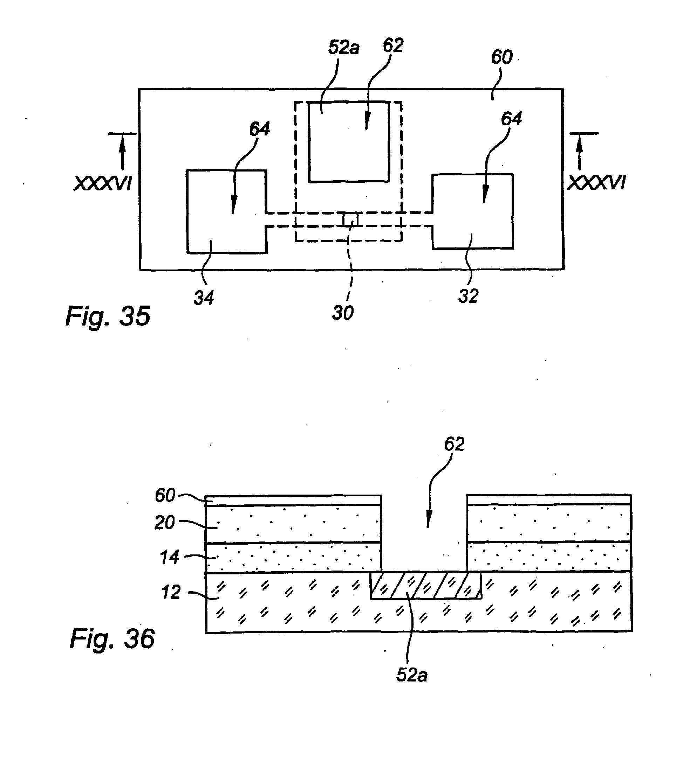

Les figures 35 et. 36 illustrent des étapes complémentaires permettant de former un accès à la grille enterrée 52a. La figure 35 est une vue de dessus du dispositif de la figure 34 qui a été recouvert d'une isolante 60 de passivation. Sur cette figure, les limites de la grille enterrée 52a sont représentées en trait discontinu. On peut observer que la grille s'étend non seulement sous l'îlot 30 mais aussi en dehors de la zone de l'îlot. Une gravure à travers la couche de passivation, de la couche de moule, ainsi qu'à travers la couche isolante enterrée, également cachée, permet de former un puits d'accès 62 et de mettre à nu la grille enterrée 52a au fond du puits. Le puits 62 est formé en dehors de la zone comprenant l'îlot. De la même façon, des puits 64 sont formés à l'aplomb des électrodes de source et de drain 32. Celles-ci sont donc également mises à nu au fond des puits. Les puits 64 à l'aplomb des électrodes de source et de drain 32 sont simplement gravés à travers la couche de passivation 60. Les puits sont ensuite comblés avec un matériau conducteur, de préférence un métal (non représenté) qui forme des bornes d'accès à la source, au drain et à la grille.

La figure 36 qui est une coupe XXXVI-XXXVI à travers le dispositif de la figure 35 montre le puits 62 au-dessus de la grille 52a avant la mise en place du métal pour les bornes d'accès.

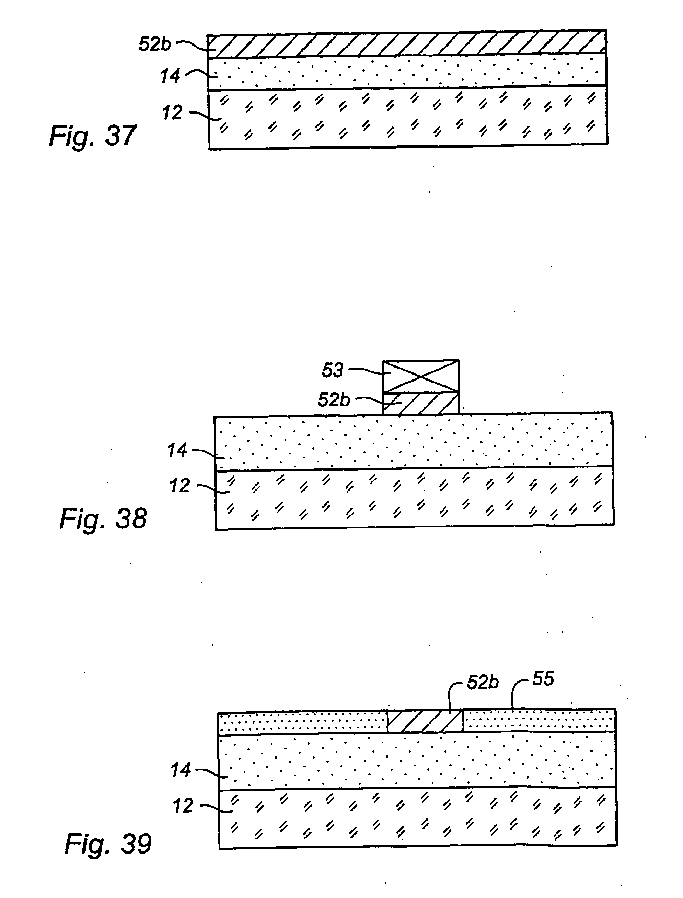

Les figures 37 à 41, illustrent une autre possibilité de fabrication d'un composant à grille isolée selon un procédé conforme à l'invention. La fabrication de la grille isolée est, dans cet exemple, également antérieure à la fabrication des électrodes de source de drain, et la fabrication du canal. La réalisation de la grille a lieu essentiellement lors de la préparation du substrat.

Comme le montre la figure 37, la préparation du substrat comprend la formation, sur une couche de support 12, d'une couche d'isolant enterrée 14 recouverte d'une couche de matériau conducteur électrique 52b. La couche conductrice est par exemple une couche métallique telle que TiN, Al ou poly-Si dopé in situ ou une couche de semi-conducteur dopée de façon à augmenter sa conductivité. Elle est soumise à une gravure, en utilisant un masque de gravure 53 visible à la figure 38. Le masque de gravure 53 permet de préserver lors de la gravure une partie de la couche conductrice 52b. Cette partie constitue la grille. La formation de la grille 52b est suivie par le dépôt d'une couche de matériau isolant électrique 55, par exemple un oxyde de silicium, puis par le planage de cette couche avec arrêt sur la grille 52b Le planage permet d'obtenir, comme le montre la figure 39, une couche d'isolant 55 avec une surface plane à laquelle affleure la grille 52b.

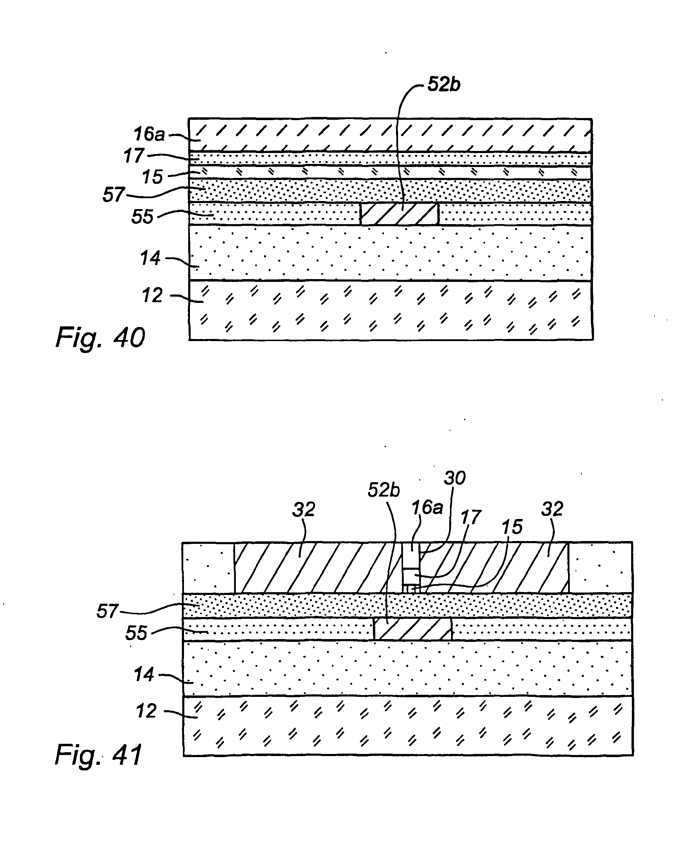

Sur cette surface plane, on forme ensuite, et dans l'ordre, une couche d'isolant de grille 57, une couche mince de semi-conducteur 15, une éventuelle couche de relaxation 17 et une couche de recouvrement 16a. Ces couches, qui apparaissent à la figure 40 sont les mêmes que celles déjà évoquées en référence à la figure 21, à laquelle on peut se reporter.

Les opérations qui suivent concernent la définition de l'îlot et la formation des électrodes de source et de drain. Ces opérations correspondent sensiblement à celles exposées en référence aux figures 21 à 30, et leur description détaillée n'est donc pas reprise ici. On obtient, au terme de ces opérations, un dispositif conforme à la figure 41. On peut observer que l'emplacement de l'îlot 30, déterminé pour l'essentiel par celui des masques de gravure successifs non représentés ici, coïncide sensiblement avec la partie médiane de la grille 52b, considérée selon la direction qui relie la source et le drain. La grille 52b séparée ainsi du canal 15 par la couche d'isolant de grille 57 fait donc face audit canal ainsi qu'à une partie des électrodes 32 de source et de drain.

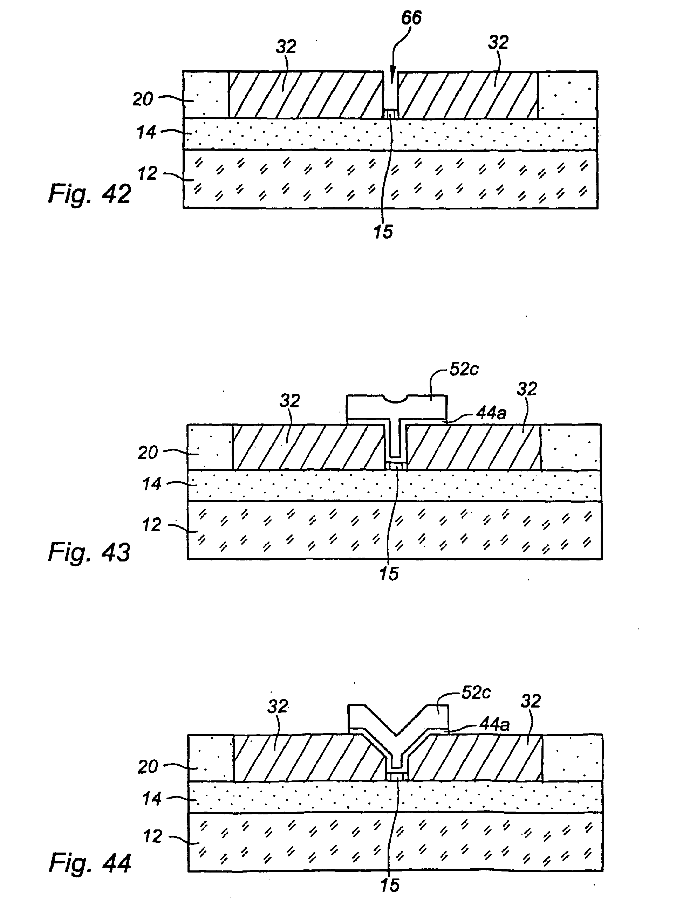

Les figures 42 à 44 illustrent un dernier exemple de fabrication de la grille. La figure 42 montre un dispositif identique à celui de la figure 30 auquel on a retiré, par gravure sélective, la couche de recouvrement et la couche de relaxation. Le retrait de ces couches conduit à la mise à nu de la portion de couche de semi-conducteur 15 formant le canal. Cette portion se trouve au fond d'un puits repéré avec la référence 66.

La formation de la grille est poursuivie par le dépôt d'une couche d'isolant de grille puis par le dépôt d'une couche de matériau conducteur. Ces couches, visibles à la figure 43, sont d'abord déposées de façon à recouvrir la surface libre du dispositif sur laquelle débouche le puits 66, ainsi que de façon à combler le puits 66. En d'autres termes la couche de matériau conducteur dans laquelle est formée la grille s'étend jusqu'au canal 15 au fond du puits, dont elle n'est séparée et isolée que par la couche d'isolant de grille. Une gravure selon un masque non représenté permet ensuite de mettre en forme la grille 52c visible sur la figure 43. La couche d'isolant de grille 44a y est également représentée.

La figure 44 montre une variante de ce procédé dans laquelle on a pratiqué une sur-gravure lors de la formation du puits 66. La sur-gravure, également sélective, en permet d'entamer également le matériau des électrodes de sorte à provoquer la formation de facettes à la bordure du puits.

Les facettes permettent comme le montre la figure, un meilleur accès de la grille 52c à la région du canal 15.

### DOCUMENTS CITES

*(1)* 2 749 977
*(2)* W. Chen, H. Ahmed, K. Nakazato, Appl. Phys. Letts 66,3383 (1995),
*(3)* I. Kim et al. IEDM 1998, 5.2.1,
*(4)* J.W. Park, Appl. Phys; Letts, vol. 75, n° 5, P.566, 1999,
*(5)* D. Kern, Microelect. Eng. 46(1999),141-144,
*(6)* Y. Takahashi et al., Int. J. Electronics, vol 86, n° 5, p. 605, 1999,
*(7)* T. Hiramoto, superlattices and Microstructures, vol. 25, n° 1/2, p. 263, 1999,
*(8)* Coulomb Blocade in silicon nano-pillars, D.M. Pooley and H. Ahmad Applied physics Letters, vol. 74, n° 15, P. 2191,
*(9)* L. Palun, MNE 1999, thèse 2000,
*(10)* T. Futatsugi et al. Fujitsu Sci. Tech. J. 34,2, pp.142-152,
*(11)* Nakajima et al . J Vac Sci Technol B17(5) Sept/oct 1999 2163,
*(12)* F.E. Prins et al., Nanotechnology 10 (1999) 132-134,
*(13)* IEEE ELECTRON DEVICE LETTERS, vol. 18, N° 6? JUNE 1997, PP 278-280, "Room Temperature Operation Of A Quantum-Dot Flash Memory", J.J. Welser, Sandip Tiwari, S.Rishton, K.Y. Lee and Y. Lee,
*(14)* Jpn. J. Appl. Phys. Vol. 38 (1999), pp. 396-398, Part 1, n° 1B, January 1999, ©1999 Publication Board, Japanese Journal of Applied Physics, "Fabrication of Nano-Scale Point Contact Metal-Oxide-Semiconductor Field-Effect-Transistors Using Micrometer-Scale Design Rule", Institute of Industrial Science, University of Tokyo, 7-22 Roppongi, Minato-ku, Tokyo 106-8558 Japn.

## Revendications

1. Procécé de fabrication d'une microstructure comprenant un îlot (30) de matière confiné entre deux électrodes (32) formant des languettes (32b), l'îlot de matière présentant des flancs latéraux parallèles et des flancs latéraux perpendiculaires aux languettes, **caractérisé en ce que**, les flancs latéraux de l'îlot étant définis par gravure d'au moins une couche (16, 116) , dite couche de gabarit, et les languettes étant formées par damasquinage, le procédé comprend une première gravure de la couche de gabarit selon un premier masque de gravure (18) présentant au moins une partie filiforme, et une deuxième gravure de la couche de gabarit, postérieure à la première gravure, selon un deuxième masque de gravure (22) présentant également au moins une partie filiforme, orientée selon une direction formant un angle non nul avec une direction d'orientation de la partie filiforme du premier masque, au voisinage d'un emplacement de formation de l'îlot.

2. Procédé selon la revendication 1, dans lequel on utilise comme couche de gabarit (116) un empilement d'au moins deux couches (15, 16a) de matériaux différents.

3. Procédé selon la revendication 1, dans lequel l'angle formé entre les directions d'orientation des premier et deuxième masques est sensiblement droit.

4. Procédé selon la revendication 2 dans lequel, lors de la première gravure, on confère à au moins une partie de ladite couche de gabarit, dite empreinte positive, et située hors de l'emplacement de formation de l'îlot, une forme correspondant à celle des électrodes.

5. Procédé selon la revendication 1 ou 3, dans lequel après la première gravure, lors de laquelle on forme dans la couche de gabarit une empreinte positive correspondant au premier masque, et avant la deuxième gravure, on forme autour de ladite empreinte positive, une couche (20), dite couche de moule, épousant la forme de l'empreinte positive, dans lequel on élimine une partie de l'empreinte positive non protégée par un deuxième masque (22), lors de la deuxième gravure, pour former avec la couche de moule, au moins une empreinte négative (24) correspondant à un emplacement pour au moins une électrode (32), et dans lequel on effectue un dépôt conformé de matériau conducteur dans l'empreinte négative (24), pour former ladite électrode.

6. Procédé selon la revendication 5 comprenant en outre un planage du matériau conducteur.

7. Procédé selon la revendication 5, comprenant en outre un planage de la couche de moule (20), lorsque celle-ci recouvre l'empreinte positive, pour mettre à nu une face de gravure de l'empreinte positive.

8. Utilisation du procédé selon l'une quelconque des revendications précédentes pour la formation d'un composant choisi parmi les transistors à effet de champ, les transistors à blocage de coulomb, et les mémoires, dans lesquels les électrodes forment respectivement des source et drain.

9. Procédé de fabrication d'un transistor comprenant les étapes suivantes :
- le dépôt d'une couche de gabarit (16) en un matériau isolant électrique sur une couche isolante (14) d'un substrat,
- la formation d'un îlot de matière (30) confiné entre des électrodes (32) de source et de drain, formant des languettes,
- la formation, au-dessus des languettes d'une couche de canal (40) recouvrant l'îlot de matière, et
- la formation d'une grille isolée disposée en regard de-l'îlot de matière,
dans lequel, la formation de l'îlot de matière (30) confiné entre les électrodes de source et de drain, est conforme à l'une quelconque des revendications 1 à 6, en utilisant la couché de gabarit.

10. Procédé selon la revendication 9, dans lequel la couche de canal (40) est séparée des électrodes (32) par une couche d'isolant tunnel (38).

11. Procédé de fabrication d'un transistor comprenant les étapes suivantes :
- la formation d'un substrat avec une couche isolante enterrée (14) supportant un empilement de couches (116) comportant dans l'ordre à partir de la couche isolante enterrée, une couche de semi-conducteur (15) et une couche de recouvrement (16a),
- la formation d'un îlot (30) de matière confiné entre des électrodes (32) de source et de drain, formant des languettes, et,
- la formation d'une grille, isolée de la couche de semi-conducteur, et disposée en regard de l'îlot de matière,
dans lequel, la formation de l'îlot de matière confiné entre les électrodes de source et de drain, est conforme à l'une quelconque des revendications 1 à 6, en utilisant l'empilement de couches (116) comme couche de gabarit.

12. Procédé selon la revendication 11, dans lequel l'empilement de couches (116) comprend en outre une couche de relaxation (17) disposée entre la couche de semi-conducteur (15) et la couche de recouvrement (16a).

13. Procédé selon la revendication 11, comprenant: en outre une étape d'oxydation thermique des flancs de la couche de semi-conducteur, postérieurement à la formation de l'îlot (30), et antérieurement à la formation des électrodes (32) de source et de drain pour former des couches d'isolant tunnel (37).

14. Procédé selon la revendication 11, dans lequel la formation du substrat comprend une étape d'amincissement de la couche de semi-conducteur (15), précédant la formation de la couche de relaxation.

15. Procédé selon la revendication 11, dans lequel la formation de la grille, postérieure à la formation de l'îlot comprend l'élimination de la couche de recouvrement (16a) pour former un puits (66) au-dessus de la couche de semi-conducteur (15) de l'îlot (30), et la formation, dans l'ordre, d'une couche d'isolant de grille (44a) et d'une couche de grille (52c) s'étendant dans le puits jusque sur la couche de semi-conducteur (15).

16. Procédé selon la revendication 11, dans lequel le substrat comprend un couche de semi-conducteur (12) sous la couche isolante enterrée (14) et dans lequel la formation de la grille (52b), antérieure à la formation de l'ilot, comprend le dopage local de ladite, couche de semi-conducteur; le dopage s'étendant dans une région coïncidant avec un emplacement de l'îlot.

17. Procédé selon la revendication 16, dans lequel on réalise le dopage par implantation à travers la couche isolante enterrée (14) et à travers l'empilement de couches (116).

18. Procédé selon la revendication 16, dans lequel on effectue un dopage s'étendant également dans une zone située hors de la région coïncidant avec l'emplacement de l'îlot, et dans lequel on forme un puits d'accès (62) à ladite zone dopée de la couche de semi-conducteur, également en dehors de l'emplacement de l'îlot.

19. Procédé selon la revendication 16, dans lequel le dopage a lieu à travers la couche de semi-conducteur (15) de l'empilement et à travers la couche isolante enterrée (14).

20. Procédé selon la revendication 11, comprenant, avant la formation de l'empilement (116) , le dépôt sur le substrat d'une couche de matériau conducteur, la gravure de ladite couche pour définir une grille 52b, le dépôt d'une couche de matériau isolant électrique (55), le planage de cette couche jusqu'à atteindre la grille, et la formation d'une couche d'isolant de grille (44b) recouvrant la grille, l'empilement étant formé sur la couche d'isolant de grille.

## Claims

1. A method for producing a microstructure comprising an island (30) of material confined between two electrodes (32) forming pads, the island of material having lateral flanks running parallel to and lateral flanks running perpendicular to the pads, **characterized in that**, the lateral flanks of the island being defined by etching of at least one layer (16, 116), called the template layer, and the pads being formed by damascening, the method comprises a first etching of the template layer using a first etching mask (18) having at least one filiform part and a second etching of the template layer, subsequent to the first etching, using a second etching mask (22) also having at least one filiform part, oriented in a direction forming a non-zero angle with a direction of orientation of the filiform part of the first mask, in the vicinity of the site of formation of the island.

2. The method according to Claim 1, wherein a stack of at least two layers (15, 16a) of different materials are used as the template layer (116).

3. The method according to Claim 1, wherein the angle formed between the directions of orientation of the first and the second masks is essentially a right angle.

4. The method according to Claim 2, wherein, at the time of the first etching, a form corresponding to that of the electrodes is given to at least one part of said template layer, called the positive impression, and situated outside of the site of formation of the island.

5. The method according to Claim 1 or 3, wherein after the first etching, at the time of which a positive impression is formed in the template layer corresponding to the first mask and, before the second etching, a layer (20) called the mold layer is formed around said positive impression, said layer taking on the form of the positive impression, in which a part of the unprotected positive impression is removed by a second mask (22) at the time of the second etching, in order to form with the mold layer at least one negative impression (24) corresponding to a site for at least one electrode (32) and into which a conductor material is uniformly deposited into the negative impression (24) for forming said electrode.

6. The method according to Claim 5, comprising in addition planishing of the conductor material.

7. The method according to Claim 5, comprising in addition planishing of the mold layer (20), when the latter covers the positive impression, in order to expose one etching face of the positive impression.

8. Use of the method according to any one of the above claims for forming a component chosen from the group comprising field-effect transistors, Coulomb blockage transistors and memories, in which the electrodes form the source and the drain, respectively.

9. A method for producing a transistor comprising the following steps :
- deposition of a template layer (16) of an electrically insulating material onto an insulating layer (14) of a substrate;
- formation of an island of material (30) confined between the source and the drain electrodes (32), forming pads;
- formation over the pads of a channel layer (40) covering the island of material, and
- formation of an insulated gate deposited facing the island of material,
wherein the formation of the island of material (30) confined between the source and the drain electrodes conforms to any one of Claims 1 to 6, by using the template layer.

10. The method according to Claim 9, wherein the channel layer (40) is separated from the electrodes (32) by a insulator tunnel layer (38).

11. A method for producing a transistor comprising the following steps :
- formation of a substrate with an embedded insulating layer (14) supporting a stack of layers (116) comprising in order, starting from the embedded insulating layer, a semiconductor layer (15) and a covering layer (16a);
- formation of an island (30) of material confined between the source and the drain electrodes (32), forming pads, and
- formation of a gate, insulated from the semiconductor layer and arranged facing the island of material,
wherein the formation of the island of material confined between the source and the drain electrodes conforms to any one of Claims 1 to 6 by using the stack of layers (116) as the template layer.

12. The method according to Claim 11, wherein the stack of layers (116) comprises in addition a relaxation layer (17) arranged between the semiconductor layer (15) and the covering layer (16a).

13. The method according to Claim 11, comprising in addition a step of thermal oxidation of the flanks of the semiconductor layer subsequent to the formation of the island (30) and prior to the formation of the source and of the drain electrodes (32) to form insulator tunnel layers (37).

14. The method according to Claim 11, wherein the formation of the substrate comprises a step of thinning the semiconductor layer (15), preceding the formation of the relaxation layer.

15. The method according to Claim 11, wherein the formation of the gate, subsequent to the formation of the island, comprises the elimination of the covering layer (16a) to form a well (66) above the semiconductor layer (15) of the island (30) and the formation, in order, of a gate insulator layer (44a) and a gate layer (52c) extending into the well up to the semiconductor layer (15).

16. The method according to Claim 11, wherein the substrate comprises a semiconductor layer (12) under the embedded insulating layer (14) and wherein the formation of the gate (52b), prior to the formation of the island, comprises local doping of said semiconductor layer, said doping extending into a region coinciding with a site of the island.

17. The method according to Claim 16, wherein doping is done by implantation across the embedded insulating layer (14) and across the stack of layers (116) .

18. The method according to Claim 16, wherein doping is done extending also into a zone situated outside of the region coinciding with the site of the island and in which an access well (62) is formed at said doped zone of the semiconductor layer, also outside of the site of the island.

19. The method according to Claim 16, wherein the doping is done across the semiconductor layer (15) of the stack and across the embedded insulating area (14).

20. The method according to Claim 11, comprising, prior to the formation of the stack (116), deposition onto the substrate of a layer of conductor material, etching of said layer for defining a gate (52b), deposition of a layer of electrical insulator material (55), planarizing of this layer until reaching the gate, and the formation of a gate insulator layer (44b) covering the gate, the stack being formed on the gate insulator layer.

## Patentansprüche

1. Verfahren zur Herstellung einer Mikrostruktur mit einer Materialinsel (30), eingefugt zwischen zwei Elektroden (32), die Zungen (32b) bilden, wobei die Materialinsel parallele Seitenflanken und senkrechte Seitenflanken in Bezug auf die Zungen aufweist,
**dadurch gekennzeichnet, dass** die Seitenflanken der Insel durch Ätzung von mindestens einer Schablonenschicht genannten Schicht (16, 116) definiert werden und die Zungen durch Tauschierung gebildet werden, wobei das Verfahren umfasst: eine erste Ätzung der Schablonenschicht gemäß einer ersten Ätzmaske (18) mit wenigstens einem filiformen Teil, und nach der ersten Ätzung eine zweite Ätzung der Schablonenform gemäß einer zweiten Ätzmaske (22) mit ebenfalls wenigstens einem filiformen Teil, ausgerichtet entsprechend einer Richtung, die einen Nichtnullwinkel mit einer Orientierungsrichtung des filiformen Teils der ersten Maske bildet, in der Nähe bzw. Umgebung einer zur Bildung der Insel vorgesehenen Stelle.

2. Verfahren nach Anspruch 1, bei dem man als Schalblonenschicht (116) einen Stapel von wenigstens zwei Schichten (15, 16a) aus unterschiedlichen Materialien benutzt.

3. Verfahren nach Anspruch 1, bei dem der zwischen den Orientierungsrichtungen der ersten und der zweiten Maske gebildete Winkel im Wesentlichen gerade ist.

4. Verfahren nach Anspruch 2, bei dem man während der ersten Ätzung wenigstens einem Teil der genannten Schablonenschicht, Konvexität genannt und außerhalb der Stelle bzw. des Platzes zur Bildung der Insel befindlich, eine Form verleiht, die derjenigen der Elektroden entspricht.

5. Verfahren nach Anspruch 1 oder 3, bei dem man nach der ersten Ätzung, während der man in der Schablonenschicht eine der ersten Maske entsprechende Konvexität ausbildet, und vor der zweiten Ätzung um die genannte Konvexität herum eine sich an die Form der Konvexität anschmiegende Formschicht genannte Schicht (20) ausbildet, bei dem man einen Teil der nicht durch eine zweite Maske (22) geschützten Konvexität während der zweiten Ätzung eliminiert, um mit der Formschicht wenigstens eine einer Stelle für wenigstens eine Elektrode (32) entsprechende Konkavität (24) auszubilden, und bei dem man eine konforme Abscheidung aus leitfähigem Material in der Konkavität (24) realisiert, um die genannte Elektrode zu bilden.

6. Verfahren nach Anspruch 5 mit außerdem einer Planarisierung des leitfähigen Materials.

7. Verfahren nach Anspruch 5 mit außerdem einer Planarisierung der Formschicht (20), wenn diese die Konvexität bedeckt, um eine Ätzfläche der Konvexität bloßzulegen.

8. Abwendung des Verfahrens nach einem der vorangehenden Ansprüche zur Bildung eines Bauteils, ausgewählt unter den Feldeffekttransistoren, den Coulomb-Blockade-Transistoren und den Speichern, bei denen die Elektroden jeweils Source und Drain bilden.

9. Verfahren zur Herstellung eines Transistors, die folgenden Schritte umfassen:
- die Abscheidung einer Schablonenschicht (16) aus einem elektrisch isolierenden Material auf einer isolierenden Schicht (14) eines Substrats,
- die Ausbildung einer Materialinsel (30), eingefugt zwischen den Zungen bildenden Source- und Drainelektroden (32),
- die Bildung einer die Materialinsel (30) überdeckenden Kanalschicht (40) über den Zungen, und
- die Ausbildung einer isolierten Steuerelektrode, der Materialinsel gegenüber angeordnet,
bei dem die Ausbildung der zwischen den Source- und Drainelektroden eingefügten Materialinsel (30) einem der Ansprüche 1 bis 6 entspricht und dabei die Schablonenschicht benutzt wird.

10. Verfahren nach Anspruch 9, bei dem die Kanalschicht (40) durch eine Tunnel-Isolationsschicht (38) von den Elektroden (32) getrennt ist bzw. wird.

11. Verfahren zur Herstellung eines Transistors, die folgenden Schritte umfassend:
- die Bildung eines Substrats mit einer vergrabenen Isolierschicht (14), einen Schichtenstapel (110) tragend, der außer der vergrabenen Isolierschicht noch eine Halbleiterschicht (15) und eine Abdeckschicht (16a) umfasst,
- die Ausbildung einer Materialinsel (30), eingefügt zwischen den Zungen bildenden Source- und Drainelektroden (32), und
- die Ausbildung einer Steuerelektrode bzw. eines Gates, isoliert von der Halbleiterschicht und der Materialinsel gegenüber angeordnet,
bei dem die Ausbildung der zwischen den Source- und Drainelektroden eingefügten Materialinsel (30) einem der Ansprüche 1 bis 6 entspricht und dabei der Schichtenstapel (116) als Schablonenschicht benutzt wird.

12. Verfahren nach Anspruch 11, bei dem der Schichtenstapel (116) außerdem eine Relaxationsschicht (17) umfasst, abgeschieden zwischen der Halbleiterschicht (15) und der Abdeckungsschicht (10a).

13. Verfahren nach Anspruch 11, das außerdem, vor der Bildung der Insel (30) und nach der Bildung der Source- und Drainelektroden (32), einen Schritt zur thermischen Oxidation der Flanken der Halbleiterschicht umfasst, um Tunnel-Isolationsschichten (37) zu bilden.

14. Verfahren nach Anspruch 11, bei dem die Bildung des Substrats einen der Bildung der Relaxationsschicht vorausgehenden Schritt zur Dünnung der Halbleiterschicht (15) umfasst.

15. Verfahren nach Anspruch 11, bei dem die Bildung der des Gates nach der Bildung der Insel umfasst: die Eliminierung der Abdeckungsschicht (16a), um über der Halbleiterschicht (15) der Insel (30) einen Schacht (66) zu bilden, und nacheinander die Bildung einer Gate-Isolationsschicht (44a) und einer Gate-Schicht (52c), die sich bis zur Halbleiterschicht (15) in den Schacht hinein erstrecken.

16. Verfahren nach Anspruch 11, bei dem das Substrat eine Halbleiterschicht (12) umfasst, unter der vergrabenen Isolierschicht (14), und bei dem die Bildung des Gates (52b) nach der Bildung der Insel die lokale Dotierung der genannten Halbleiterschicht umfasst, wobei die Dotierung sich in einem mit einem Platz der Insel zusammenfallenden Bereich erstreckt.

17. Verfahren nach Anspruch 16, bei dem man die Dotierung durch Implantation durch die vergrabene Isolierschicht (14) und durch den Schichtenstapel (116) hindurch ausführt.

18. Verfahren nach Anspruch 16, bei dem man eine Dotierung realisiert, die sich auch in eine Zone außerhalb des mit dem Platz der Insel zusammenfallenden Bereichs erstreckt, und bei dem man einen Zugangsschacht (62) zu der genannten dotierten Zone der Halbleiterschicht bildet, ebenfalls außerhalb des Platzes der Insel.

19. Verfahren nach Anspruch 16, bei dem die Dotierung durch die Halbleiterschicht (15) des Stapels und durch die vergrabene Isolierschicht (14) hindurch stattfindet.

20. Verfahren nach Anspruch 11, das vor der Bildung des Stapels (116) umfasst: die Abscheidung einer Halbleifierschicht auf dem Substrat, die Ätzung der genannten Schicht, um ein Gate 52b zu definieren, die Abscheidung einer Schicht aus elektrisch isolierendem Material (55), die Planarisierung dieser Schicht bis zum Erreichen des Gates, und die Bildung einer das Gate bedeckenden Gate-Isolationsschicht (44b), wobei der Stapel auf der Gate-Isolationsschicht gebildet wird.
